# EUROPÄISCHE PATENTANMELDUNG

(11) **EP 0 833 437 A2**
(43) Veröffentlichungstag der Anmeldung: **01.04.1998**
(21) Anmeldenummer: 97115482.8
(22) Anmeldetag: 06.09.1997
(51) Int. Cl.: H02P 7/74

(54) **Halbeiter-Treiber-Schaltungselement zur Ansteuerung elektrischer Lasten**

(30) Priorität: 25.09.1996 DE 19639252
(71) Anmelder: Hella KG Hueck & Co., 59552 Lippstadt (DE)
(72) Erfinder: Knittel, Otto, 59494 Soest (DE); Richter, Ralf, Nortville, MI 48167 (US)

(57) **Zusammenfassung**

Das Halbleiter-Treiberschaltungselement zur Ansteuerung elektrischer Lasten ist mit einem Halbleiterchip (12) mit mehreren integrierten elektronischen Schaltern (24,26) versehen, von denen jeder einen Steueranschluß (28,36) zum Ein- und Ausschalten des Schalters (24,26) und zwei Treiberstromanschlüsse (30,32,38,40) aufweist, zwischen denen bei eingeschaltetem Schalter (24,26) ein Treiberstrom fließt. Ferner weist die Halbleiter-Treiberschaltung elektrisch mit dem Halbleiterchip (12) verbundene Anschlußpins (16,20,34,42,44) für unter anderem ein erstes und ein zweites Spannungsversorgungspotential (18,22) und ein Gehäuse (14) auf, das den Halbleiterchip (12) umgibt und aus dem die Anschlußpins herausgeführt sind, wobei einer der beiden Treiberstromanschlüsse (30,32) mindestens eines ersten Schalters (24) elektrisch mit einem Anschlußpin (16) für das erste Spannungsversorgungspotential (18) verbunden ist und einer der beiden Treiberstromanschlüsse (38,40) mindestens eines zweiten Schalters (26) elektrisch mit einem Anschlußpin (20) für das zweite Spannungsversorgungspotential (22) verbunden ist und die jeweils anderen der beiden Treiberstromanschlüsse (32,40) des mindestens einen ersten und des mindestens einen zweiten Schalters (24,26) elektrisch mit Anschlußpins (34,42) verbunden sind, die derart aus dem Gehäuse (14) geführt sind, daß sie im Layout der Schaltungsplatine, auf der das IC-Treiberschaltungselement angeordnet wird, leicht miteinander verbunden werden können.

## Beschreibung

Die Erfindung betrifft ein Halbleiter-Treiberschaltungselement zur Ansteuerung elektrischer Lasten, wie z. B. Relais, Motoren oder dergleichen, und insbesondere ein Halbleiter-Treiber-schaltungselement, das hinsichtlich der Verschaltung mit externen Lasten frei konfigurierbar ist.

Mehrfach-Treiberschaltungselemente (nachfolgend Treiber-IC genannt), mit denen sich die Beschaltung externer elektrischer Lasten frei konfigurieren lassen, sind dem Stand der Technik bekannt. Diese Treiber-IC weisen jeweils paarweise zu Halbbrückenschaltungen verbundene, in Reihe geschaltete elektrische Schalter auf, von denen jeder einen Steuersignalanschluá zum Ein- und Ausschalten des Schalters und zwei Treiber-Stromanschlüsse aufweist, zwischen denen sich im eingeschalteten Zustand des Schalters ein Strompfad bildet, über den der Treiberstrom fließt. Pro Paar ist ein Treiberstromanschluß des einen Schalters mit einem ersten Versorgungsspannungspotential verbunden, während eine der beiden Treiberstromanschlüsse des anderen Schalters mit einem zweiten Versorgungsspannungspotential verbunden ist. Die jeweils anderen Treiberstromanschlüsse beider Schalter sind miteinander verbunden. Dieser Verbindungsschaltpunkt ist als Anschlußpin (Mittelabgriffspin) aus dem Gehäuse des IC-Treiberbauelements herausgeführt. Das bekannte Treiber-IC verfügt ferner über diverse Dateneingangspins, über die die Schalterzustände der elektronischen Schalter definierende binäre Datensignale eingebbar sind. Ein solcher Treiber-IC ist z. B. aus DE 44 40 064 A1 bekannt.

Das bekannte Treiber-IC ist bezüglich seiner Ausgangsstruktur insofern konfigurierbar, als zwei seiner Halbbrücken sich zu einer Vollbrückenschaltung verbinden lassen, indem zwischen ihre Mittelabgriffspins ein Motor geschaltet wird. Durch Ansteuerung der elektronischen Schalter dieser Vollbrücke im Gegentaktbetrieb läßt sich damit die Richtung des Stromflusses durch den Motor umkehren. Eine andere Halbbrückenausgangsstruktur läßt sich bei dem bekannten Treiber-IC dadurch realisieren, daß zwischen mehrere Halbbrücken jeweils ein Motor geschaltet wird (sogenannte Kaskadierung, d. h. in Form einer Reihenschaltung mehrerer voneinander unabhängiger Vollbrücken).

In der Praxis ist oftmals der Fall anzutreffen, daß eine zu steuernde Vorrichtung mehrere unterschiedliche elektrisch zu betreibende Einheiten aufweist, die sämtlich über die Treiber-ICs angesteuert werden sollen. Typischerweise bei einer Kfz-Klimaanlage anzutreffende Lasten sind beispielsweise die Stellmotoren für diverse Strömungsklappen sowie verschiedene Relais. Derartige Konstellationen finden sich aber auch in anderen zu steuernden Vorrichtungen. Dabei können die Relais gegen unterschiedliche Versorgungsspannungspotentiale geschaltet sein. Normalerweise handelt es sich bei diesen Versorgungsspannungspotentialen um Masse und ein positives Potential. Die Relais stellen also sowohl High-Side-Lasten als auch Low-Side-Lasten dar. Werden diese Lasten über die Halbbrückenschaltungen des bekannten Treiber-IC angesteuert, so befindet sich stets einer der beiden Schalter im ausgeschalteten, d. h. hochohmigen Zustand. Dieser Schalter kann bei dem bekannten Treiber-IC nicht mehr zur Ein- und Ausschaltung anderer Lasten eingesetzt werden.
Der Erfindung liegt die Aufgabe zugrunde, ein Mehrfach-Treiber-IC zur Ansteuerung von elektrischen Lasten zu schaffen, dessen Schalter sowohl einzeln unabhängig voneinander als auch in Kombination miteinander zur Ansteuerung elektrischer Lasten durch eine dementsprechende freie Konfigurierung verwendet werden können.

Zur Lösung dieser Aufgabe wird mit der Erfindung ein Halbleiter-Treiberschaltungselement zur Ansteuerung elektrischer Lasten vorgeschlagen, das versehen ist mit
- einem Halbleiterchip mit mehreren integrierten elektronischen Schaltern, von denen jeder einen Steueranschluß zum Ein- und Ausschalten des Schalters und zwei Treiberstromanschlüsse aufweist, zwischen denen bei eingeschaltetem Schalter ein Treiberstrom fließt,
- elektrisch mit dem Halbleiterchip verbundene Anschlußpins für unter anderem ein erstes und ein zweites Spannungsversorgungspotential und
- einem Gehäuse, das den Halbleiterchip umgibt und aus dem die Anschlußpins herausgeführt sind, wobei
- einer der beiden Treiberstromanschlüsse mindestens eines ersten Schalters ' elektrisch mit einem Anschlußpin für das erste Spannungsversorgungspotential verbunden ist,
- einer der beiden Treiberstromanschlüsse mindestens eines zweiten Schalters elektrisch mit einem Anschlußpin für das zweite Spannungsversorgungspotential verbunden ist und
- die jeweils anderen der beiden Treiberstromanschlüsse des mindestens einen ersten und des mindestens einen zweiten Schalters elektrisch mit Anschlußpins verbunden sind, die einzeln und insbesondere nebeneinanderliegend aus dem Gehäuse herausgeführt sind.

Hauptmerkmal des erfindungsgemäßen Treiber-IC ist, daß die nicht mit einer der beiden Versorgungsspannungspotentiale verbundenen Treiberstromanschlüsse eines Schalterpaares, das aus einem ersten mit dem ersten Spannungsversorgungspotential verbundenen Schalter und einem zweiten mit dem zweiten Spannungsversorgungspotential verbundenen Schalter besteht, elektrisch nicht miteinander verbunden sind, sondern vielmehr mit Anschlußpins verbunden sind, die vorzugsweise nebeneinanderliegend aus dem Gehäuse des Treiber-IC herausgeführt sind. Diese beiden nebeneinanderliegenden Anschlußpins lassen sich extern miteinander verbinden, wodurch die beiden an den Anschlußpins angeschlossenen internen elektronischen Schalter zu einer Halbbrücke geschaltet sind. Damit entspricht diese Schaltungskonfiguration einer von außen frei konfigurierbaren Halbbrücke. Zwischen zwei derartige von außen konfigurierte Halbbrücken läßt sich dann ein elektrischer Motor schalten, der damit über eine Vollbrückenschaltung mit Stromrichtungsumkehr ansteuerbar ist. Sollen über das erfindungsgemäße Treiber-IC High-Side- und Low-Side-Lasten, wie beispielsweise Relais, gesteuert werden, so bleiben die beiden nebeneinanderliegenden Anschlußpins getrennt, um mit einer High-Side-Last und einer Low-Side-Last verbunden zu werden.

Durch die bei dem erfindungsgemäßen Treiber-IC vorgesehene Unterteilung in einzelne Viertelbrückentreiber erhöht sich die Möglichkeit der freien Konfigurierbarkeit, wodurch sich das erfindungsgemäße Treiber-IC optimal ausnutzen läßt. Die einzeln herausgeführten Viertelbrückentreiber können über das Layout der Platine, auf der das erfindungsgemäße Treiber-IC angeordnet ist, von außen leicht miteinander verbunden werden, so daß sie je nach zu steuerndem Lasttyp auf für den Schaltungsentwurf einfache Weise miteinander verschaltet werden können. Das ermöglicht es, das Treiberschaltungselement gleichzeitig und unabhängig voneinander als Highside-Lowside-Halbbrücken- und Vollbrückentreiber einzusetzen.

Die Beschaltung der einzelnen Viertelbrückentreiber zu einer Halbbrückenausgangsstruktur ist für den Schaltungsdesigner insbesondere dann denkbar einfach, wenn die beiden einzeln herausgeführten Ausgangspins zweier Viertelbrückentreiber jeweils unmittelbar benachbart zueinander angeordnet sind. Durch einfache Manipulation im Layout der Platine, auf der das erfindungsgemäße Treiber-IC angeordnet ist, läßt sich also problemlos und ohne nennenswerten Aufwand aus zwei Viertelbrückentreibern eine Halbbrückenausgangsstruktur realisieren. Durch den verbesserten Ausnutzungsgrad der erfindungsgemäßen Treiber-ICs werden pro Steuerungskarte weniger IC-Treiberbausteine benötigt. Dies ist insbesondere bei kompakten zu steuernden Vorrichtungen von Vorteil, da der Platz für die elektronischen Bauelemente dort recht eingeschränkt ist. Durch den verbesserten Ausnutzungsgrad lassen sich schließlich auch Bauelementkosten einsparen, die insofern ins Gewicht fallen, als die Treiber-ICs mit vom Schaltungsdesign her aufwendigen integrierten Leistungselektronik-Schaltern versehen sind, da für die Ansteuerung der elektrischen Lasten Ströme von einigen hundert mA bis zu mehreren Ampere Stärke geschaltet werden müssen.

Was den Informationsgehalt der Ansteuer- und Diagnose-Protokolle, d. h. der Datenprotokolle betrifft, die zur Steuerung der einzelnen Schalter des erfindungsgemäßen Treiber-IC erforderlich sind, so ist anzumerken, daß sich dieser Informationsgehalt gegenüber einem Halbbrücken-Treiber-IC physikalisch bzw. logisch verdoppelt; denn für jeden elektronischen Schalter ist genau ein Bit des Datenprotokolls zugeordnet. Letztendlich verdoppeln sich bei dem erfindungsgemäßen Treiber-IC gegenüber einem herkömmlichen Halbbrücken-Treiber-IC die Anzahl an verfügbaren Ausgängen, wobei der Anwender sämtliche möglichen Ausgangskombinationen, -konfigurationen (Viertelbrücken- und Halbbrücken-Ausgangsstruktur in beliebiger Kombination miteinander) und Lasttypen (elektrische Lasten mit Stromrichtungsumkehr sowie High-Side- und Low-Side-Lasten) durch entsprechende Gestaltung der die Daten für die Steuerung der elektronischen Schalter enthaltenden Protokolle und durch die Art der externen Ausgangsverschaltung definieren kann.

Nachfolgend wird anhand der Zeichnung ein Ausführungsbeispiel der Erfindung näher erläutert. In der Zeichnung ist die interne elektrische Schaltung (teils als Blockschaltbild) sowie eine mögliche externe Beschaltung eines erfindungsgemäßen Treiber-IC dargestellt.

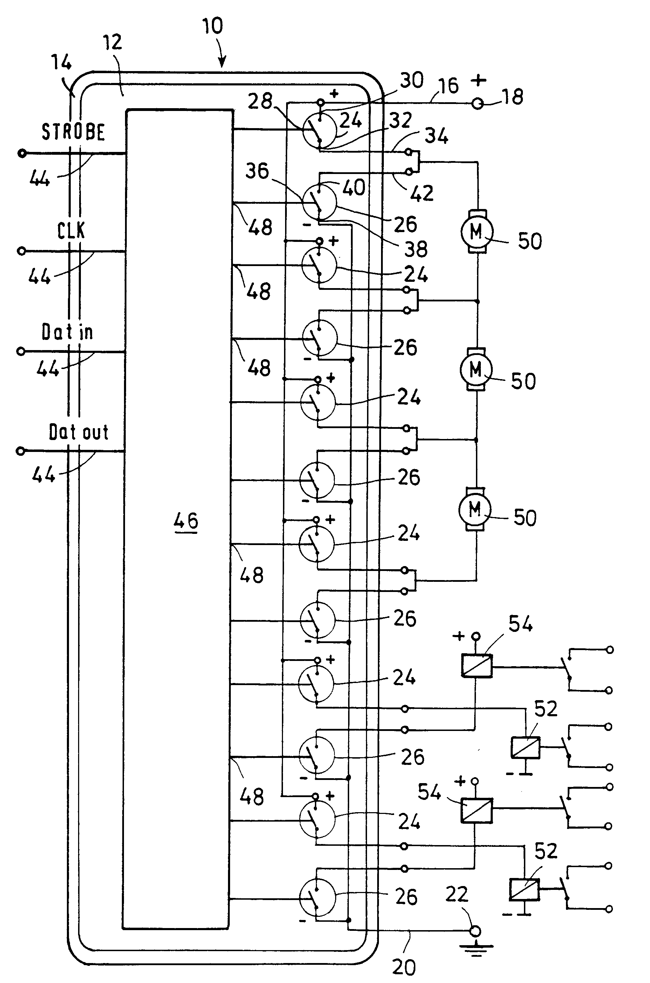

In Fig. 1 ist ein Viertelbrücken-Treiber-IC 10 dargestellt, der einen Halbleiterchip 12 aufweist, welcher in ein Kunststoffgehäuse 14 eingegossen ist. Das Treiber-IC 10 weist einen aus dem Gehäuse 14 herausgeführten Anschlußpin 16 auf, der mit einem positiven Spannungsversorgungspotential 18 verbindbar ist. An einen weiteren Anschlußpin 20 läßt sich ein zweites Spannungsversorgungspotential, in diesem Fall Masse 22 anschließen. Auf dem Halbleiterchip 12 sind eine gleiche Anzahl von ersten und zweiten elektronischen Schaltern 24, 26 integriert. Diese elektronischen Schalter 24 und 26 sind beispielsweise als Leistungs-MOS-Transistoren ausgeführt. Jeder der ersten Schalter 24 weist einen Steueranschluß 28 auf, an den ein Steuersignal zum Ein- oder Ausschalten des ersten Schalters 24 anlegbar ist. Jeder erste Schalter 24 verfügt darüber hinaus über zwei weitere Anschlüsse 30, 32, zwischen denen sich im eingeschalteten Zustand des ersten Schalters 24 ein den Treiberstrom leitender Strompfad bildet.

Während der eine Treiberstromanschluß 30 mit dem Anschlußpin 16 für das positive Spannungsversorgungspotential 18 verbunden ist, ist der andere Treiberstromanschluß 32 mit einem Anschlußpin 34 des Treiber-IC 16 verbunden, der aus dem Gehäuse 14 herausgeführt ist. Bei den ersten Schaltern 24 handelt es sich also um High-Side-Schalter.

Genauso wie die ersten Schalter 24 weisen auch die zweiten Schalter 26 einen Steuereingang 36 sowie zwei weitere Anschlüsse 38, 40 auf, zwischen denen sich bei eingeschaltetem zweiten Schalter 36 ein Strompfad ausbildet. Während der eine Anschluß 38 mit dem mit Massepotential 22 zu verbindenden Anschlußpin 20 verbunden ist, ist der andere Anschluß 40 mit einem Anschlußpin 42 des Treiber-IC 10 verbunden, der aus dem Gehäuse 14 herausgeführt ist. Die zweiten Schalter 26 sind also Low-Side-Schalter.

Das Treiber-IC 10 verfügt ferner über diverse Daten-Anschlußpins 44, über die beispielsweise ein Strobe-Signal, ein Takt-Signal, ein Dateneingabe-Signal und ein Datenausgabe-Signal zuführbar sind. Diese Signale werden einer Logik- und Ansteuerungssignal-Aufbereitungsschaltung 46 zugeführt, die pro erstem und zweitem Schalter 24, 26 einen Ausgang 48 aufweist, der mit einem der ersten und zweiten Schalter 24, 26 verbunden ist.

Wie anhand der Zeichnung zu erkennen ist, sind die beiden aus dem Gehäuse 14 herausgeführten Anschlußpins 34 und 42 eines ersten und eines zweiten Schalters 24, 26 unmittelbar benachbart zueinander angeordnet. Durch externe Verbindung dieser beiden Anschlußpins 34 und 42 lassen sich die beiden mit diesen Anschlußpins 34 und 42 verbundenen ersten und zweiten Schalter 24 und 26 zu einer Halbbrückenstruktur verbinden. In der Darstellung gemäß Fig. 1 sind jeweils vier Paare von ersten und zweiten Schaltern 24 und 26 zu vier Halbbrückenschaltungen elektrisch verbunden. Zwischen die jeweils miteinander elektrisch verbundenen Anschlußpins 34 und 42 dieser vier Halbbrückenschaltungen sind drei Elektromotore 50 als Kaskade geschaltet. Jeder Motor 50 ist also in eine Vollbrücke geschaltet, die aus zwei jeweils aus einem ersten und einem zweiten Schalter 24, 26 bestehenden Halbbrückenschaltungen besteht, wobei zwei der auf diese Weise geschalteten Halbbrücken Bestandteil jeweils zweier Vollbrücken sind.

Die in der Darstellung gemäß der Zeichnung unteren beiden Paare von ersten und zweiten Schaltern 24 und 26 werden als Viertelbrückentreiber eingesetzt, um elektrische Lasten in Form von Relais 52, 54 zu treiben. Dabei sind die Relais 52 mit den am positiven Spannungsversorgungspotential 18 liegenden High-Side-Schaltern 24 verbunden, während die Relais 54 mit den Low-Side-Schaltern 26 verbunden sind, die an Masse 22 liegen. Die beiden Relais 52 stellen also eine Low-Side-Last dar, während die beiden Relais 54 jeweils eine High-Side-Last repräsentieren.

Wie anhand der Zeichnung zu erkennen ist und sich aus der obigen Beschreibung ergibt, ist das Treiber-IC 10 durch externe Beschaltung bezüglich seiner Ausgangskonfiguration und seiner Ausgangskombination frei definierbar. Damit lassen sich sämtliche Schalter 24 und 26 des Treiber-IC 10 zur Ansteuerung von Lasten ausnutzen. Die Konfigurierung des Treiber-IC 10 ist denkbar einfach, da die einzeln und getrennt voneinander herausgeführten Ausgangsanschlüsse der einzelnen Schalter 24 und 26 in unmittelbarer Nähe zueinander angeordnet sind und lediglich elektrisch miteinander verbunden werden müssen, um beispielsweise einen Low-Side-Schalter 26 mit einem High-Side-Schalter 24 zur Bildung einer Halbbrücke miteinander zu verbinden.

## Patentansprüche

1. Halbleiter-Treiberschaltungselement zur Ansteuerung elektrischer Lasten mit
- einem Halbleiterchip (12) mit mehreren integrierten elektronischen Schaltern (24;26), von denen jeder einen Steueranschluß (28;36) zum Ein- und Ausschalten des Schalters (24;26) und zwei Treiberstromanschlüsse (30,32;38,40) aufweist, zwischen denen bei eingeschaltetem Schalter (24;26) ein Treiberstrom fließt,
- elektrisch mit dem Halbleiterchip (12) verbundene Anschlußpins (16,20,34,42,44) für unter anderem ein erstes und ein zweites Spannungsversorgungspotential (18,22) und
- einem Gehäuse (14), das den Halbleiterchip (12) umgibt und aus dem die Anschlußpins (16,20,34,42,44) herausgeführt sind, wobei
- einer der beiden Treiberstromanschlüsse (30,32) mindestens eines ersten Schalters (24) elektrisch mit einem Anschlußpin (16) für das erste Spannungsversorgungspotential (18) verbunden ist,
- einer der beiden Treiberstromanschlüsse (38,40) mindestens eines zweiten Schalters (26) elektrisch mit einem Anschlußpin (20) für das zweite Spannungsversorgungspotential (22) verbunden ist und
- die jeweils anderen der beiden Treiberstromanschlüsse (32,40) des mindestens einen ersten und des mindestens einen zweiten Schalters (24,26) elektrisch mit Anschlußpins (34,42) verbunden sind, die einzeln aus dem Gehäuse (14) herausgeführt sind.

2. Halbleiter-Treiberschaltungselement nach Anspruch 1, dadurch gekennzeichnet, daß die mit den jeweils anderen der beiden Treiberstromanschlüsse (32,40) des mindestens einen ersten und des mindestens einen zweiten Schalters (24,26) verbundenen Anschlußpins (34,42) nebeneinanderliegend aus dem Gehäuse (14) herausgeführt sind.
